Europäisches Patentamt

(19) European Patent Office

Office européen des brevets

(11) Numéro de publication: **0 267 502**
**A1**

(12) **DEMANDE DE BREVET EUROPEEN**

(21) Numéro de dépôt: 87115973.7

(22) Date de dépôt: 30.10.87

(51) Int. Cl.4: **G01R 1/20**

(30) Priorité: 05.11.86 CA 522214

(43) Date de publication de la demande:
18.05.88 Bulletin 88/20

(84) Etats contractants désignés:
CH DE FR LI SE

(71) Demandeur: **HYDRO-QUEBEC**
**75, Boulevard Dorchester Ouest**
**Montréal Québec H2Z 1A4(CA)**

(72) Inventeur: **Malewski, Ryszard, Mr.**
**190 Putney**
**St.Lambert Québec, J4P 3B1(CA)**
Inventeur: **Leclerc, Marc**
**91, Rue Marie Boulard**
**Bourcheville Québec, J4B 4B8(CA)**

(74) Mandataire: **Casalonga, Axel et al**
**BUREAU D.A. CASALONGA - JOSSE**
**Morassistrasse 8**
**D-8000 Munich 5(DE)**

(54) **Système de compensation de l'effet d'asymétrie du courant de retour sur la réponse d'un shunt de mesure de courant.**

(57) Afin de minimiser l'éffet de proximité sur la réponse d'un shunt dû à un changement de la configuration des conducteurs de retour, la présente invention propose un shunt de mesure du courant comprenant un système de compensation de l'effet d'asymétrie du courant de retour sur la réponse du shunt. A cet effet, on installe deux circuits de mesure de la différence de potentiel, chacun dans un plan respectif longitudinal du shunt. Le parcours de chacun de ces circuits doit être optimisé pour la configuration de calibration du shunt. Ces circuits de mesure ont leurs bornes respectives de départ et d'arrivée reliées en parallèle. Plus particulièrement, la présente invention propose des shunts de mesure à géométrie tubulaire et rectangulaire comprenant de tels systèmes de compensation.

Fig. 1

Xerox Copy Centre

# SYSTEME DE COMPENSATION DE L'EFFET D'ASYMETRIE DU COURANT DE RETOUR SUR LA REPONSE D'UN SHUNT DE MESURE DE COURANT

La présente invention se rapporte à un système de compensation de l'effet d'asymétrie du courant de retour sur la réponse d'un shunt de mesure lorsque la configuration des conducteurs de retour varient.

Un shunt est un dispositif de mesure des courants forts transitoires, alternatifs et continus. Il fonctionne sur le principe que le courant produit une différence de potentiel sous la résistance du shunt et que cette différence de potentiel permet par la loi d'Ohm, de calculer l'intensité du courant.

Le circuit de mesure de la différence de potentiel est constitué d'un fil isolé qui est inséré dans une rainure coupée à l'intérieur de l'élément résistif et qui est soudé à l'extrémité opposée à la sortie.

Les propriétés de mesure d'un shunt sont caractérisées par la valeur nominale de la résistance ainsi que par la réponse à l'impulsion de courant en forme d'échelon. Idéalement la réponse obtenue à la sortie du shunt devrait être une réplique fidèle de l'onde échelon de courant appliquée à son entrée. La réponse d'un shunt réel s'écarte toujours de l'onde échelon à cause premièrement de l'effet pelliculaire dans le matériau résistif et deuxièmement à cause de l'effet de proximité des courants de retour.

L'effet de proximité des courants de retour est nul lorsque le retour est à une distance infinie ou lorsque le retour extérieur est de forme tubulaire concentrique et que le courant qui y circule est réparti uniformément sur sa circonférence.

Pour une configuration donnée du shunt et des conducteurs de retour, en particulier pour une configuration de calibration, l'écart entre la réponse du shunt et l'onde appliquée peut-être réduit en optimisant le parcours du circuit de mesure à l'intérieur de l'élément résistif. Un changement de la géométrie de la configuration du shunt et des conducteurs de retour affecte en général la réponse du shunt et en limite l'utilisation.

Une première réalisation de l'invention consiste en la mise au point d'un moyen de compensation des effets d'asymétrie du courant de retour dans un shunt de mesure.

Une autre réalisation de l'invention a trait à un shunt de mesure de géométrie tubulaire comprenant un moyen de compensation des effets d'asymétrie de retour du courant.

Une autre réalisation de l'invention consiste en un shunt à géométrie rectangulaire comprenant un moyen de compensation des effets d'asymétrie du courant de retour sur la réponse du shunt de mesure.

Dans sa construction la plus large, la présente invention propose un shunt de mesure du courant comprenant un moyen de compensation de l'effet d'asymétrie du courant de retour sur la réponse du shunt, ledit moyen de compensation étant caractérisé par l'installation de deux circuits de mesure de la différence de potentiel chacun dans un plan restectif longitudinal du shunt. Le parcours de chacun de ces circuits doit être optimisé pour la configuration de calibration du shunt. Ces circuits de mesure ont leur bornes respectives de départ et d'arrivée reliées en parallèle afin de faire une somme pondérée de leurs réponses.

Ceci a pour effet de minimiser les variations de la réponse du shunt lorsque la configuration du circuit de courant for "in situ" ne correspond pas à la configuration de calibration.

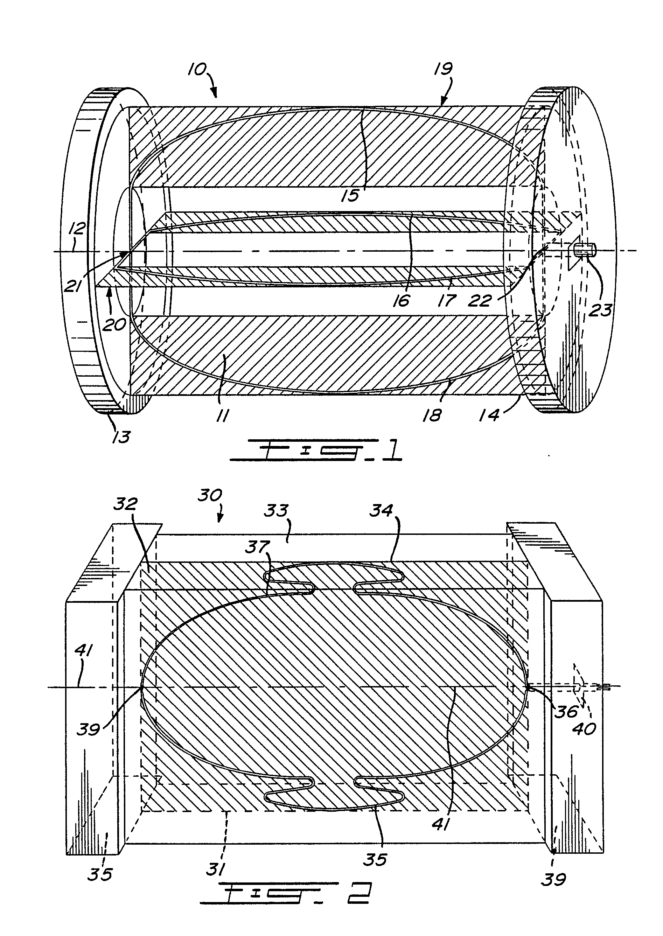

Nous décrirons maintenant des réalisations préférees de la présente invention en se référant aux exemples illustrés aux Figures 1 et 2 du présent mémoire descriptif représentant respectivement un shunt de mesure à géométrie tubulaire (figure 1) et un shunt de mesure à géométrie rectangulaire (figure 2) muni d'un moyen de compensation de l'effet d'asymétrie du courant de retour. La géométrie des shunts présentée dans ces deux exemples ont une symétrie par rapport à l'axe central. Les sondes de tension installées dans deux plans longitudinaux symétriques présenteront le même parcours si la symétrie de courant est aussi assurée par la disposition des conducteurs de retour.

Dans la figure 1, le shunt (10) est constitué d'un élément résistif tubulaire (11) reliant entre-elles une borne d'entrée (13) et une borne de sortie (14) du courant fort. Ledit élément résistif (11) est coupé selon deux plans de symétrie longitudinaux (19) et (20), ces deux plans passant par l'axe de symétrie (12) et étant perpendiculaires l'un à l'autre. Le plan de symétrie (19) comprend deux circuits de mesure (15) et (18) constitués chacun par une rainure dans laquelle est inséré un conducteur isolé de mesure et dont les chemins respectifs sont établis suivant le parcours optimisé pour la configuration de l'utilisation. Semblablement, le plan de symétrie (20) contient deux circuits de mesure (16) et (17) et dont le chemin est établi suivant le parcours optimisé pour la configuration de calibration. Les différents conducteurs de mesure ont leurs extrémités de départ reliées en parallèle à un point commun de départ (21) branché à la borne d'entrée du courant fort (13) et leurs extrémités d'arrivées reliées également en parallèle à un point d'arrivée commun (22) branchés à la fiche coaxiale de sortie (23) concentrique à la borne de sortie du courant fort (14).

Dans ce type de shunt, les bornes d'entrée et de sortie du courant fort sont généralement constituées de disques massifs (13, 14) enlaiton ou en cuivre. L'élément résistif tubulaire (11) est généralement constitué par un alliage résistif tel que du constantan, du manganin ou du nichrome.

Dans la figure 2, représentant un shunt plat ou (rectangulaire), ledit shunt (30) est constitué d'un élément résistif rectangulaire (31) reliant entre-elles une borne d'entrée du courant fort (35) et une borne dè sortie du courant fort (39). L'élément résistif rectangulaire (31) est composé de deux barres rectangulaires juxtaposées (32) et (33) dont le plan de juxtaposition est un plan longitudinal de symétrie (34) passant par l'axe de symétrie longitudinal du shunt (41). Le plan de symétrie (34) contient deux circuits de mesure dont les chemins respectifs sont établis suivant le parcours optimisé pour la configuration de calibration. Ces circuits demesure sont constitués d'une rainure à l'intérieur de laquelle est disposé un conducteur isolé de mesure dont les extrémités respectives de départ sont reliées à un point commun de départ (39) branché à la borne d'entrée du courant fort (41), et dont les extrémités respectives d'arrivées sont reliées à un point commun d'arrivée (36) branché à la fiche coaxiale de sortie (40) qui passe du travers de la borne de sortie du courant fort (39).

Dans ce type de shunt, les bornes d'entrée et de sortie sont généralement constituées de barres en laiton ou en cuivre. L'élément résistif rectangulaire de tels shunts est généralement constitué d'un alliage résistif tel que du constantan, du manganin ou du nichrome.

De tels shunts compensés peuvent être utilisés lorsque la configuration des circuits adjacents porteurs de courant peut être midofiée et que la configuration ne correspond plus à la configuration de calibration.

Nous retrouverons plus particulièrement des applications typiques de tels shunts dans des laboratoires d'essais et dans les systèmes d'alimentation à fort courant.

**Revendications**

Les réalisations de l'invention, au sujet desquelles un droit exclusif de propriété ou de privilège est revendiqué sont définies comme il suit:-

1. Un shunt de mesure du courant comprenant un moyen de compensation de l'effet d'asymétrie du courant de retour sur la réponse du shunt, ledit moyen de compensation étant caractérisé par la présence d'au moins deux circuits de mesure de la différence de potentiel chacun dans un plan respectif longitudinal du shunt, chacun desdits circuits ayant un parcours optimisé pour la configuration de calibration du shunt, lesdits circuits de mesure ayant leurs extrémités respectives de départ et d'arrivée reliées en parallèle.

2. Un shunt de mesure du courant tel que revendiqué à la revendication 1 dans lequel lesdits circuits de mesure sont symétriques l'un à l'autre par rapport à l'axe de symétrie longitudinal du shunt.

3. Un shunt de mesure du courant tel que revendiqué à la revendication 1, dans lequel le plan contenant les circuits de mesure est un plan de symétrie.

4. Un shunt de mesure du courant tel que revendiqué aux revendications 1, 2 ou 3, présentant une géométrie tubulaire.

5. Un shunt de mesure du courant tel que revendiqué aux revendications 1, 2 ou 3, présentant une géométrie rectangulaire.

6. Un shunt de mesure tubulaire constitué d'un élément résistif tubulaire reliant entre-elles une borne d'entrée et une borne de sorie du courant fort appliqué au shunt, ledit élément résistif comprenant au moins deux circuits de mesure de la différence de potentiel produite dans le shunt établi suivant le parcours optimisé pour la configuration de cali bration, lesdits circuits étant situés deux à deux dans différents plans longitudinaux du shunt et étant symétriques l'un à l'autre par rapport à l'axe de symétrie longitudinal du sunt et ayant leurs bonres respectives de départ reliées en parallèle à un point commun de départ branché à la borne d'entrée du courant fort appliqué au shunt et leurs bornes respectives d'arrivée reliées en parallèle à un point commun d'arrivée branché à une fiche coaxiale de sortie concentrique à la borne de sortie du courant fort appliqué au shunt.

7. Un shunt de mesure tubulaire tel que revendiqué à la revendication 5, dans lequel l'élément résistif comprend quatre circuits de mesure de la différence de potentiel produite dans le shunt, lesdits circuits étant situés deux à deux dans des plans de symétrie longitudinaux perpendiculaires.

8. Un shunt de mesure tubulaire tel que revendiqué aux revendications 5 ou 6, dans lequel les bornes d'entrée et de sortie du courant fort appliqué au shunt sont constituées par des anneaux ou disques massifs en laiton.

9. Un shunt de mesure tubulaire tel que revendiqué aux revendications 5 ou 6 dans lequel les bornes d'entrée et de sortie du courant fort appliqué au shunt sont constituées par des anneaux ou disques massifs en cuivre.

10. Un shunt de mesure rectangulaire constitué d'un élément résistif rectanguiaie reliant entre-elles une borne d'entrée et une borne de sortie du courant fort appliqué au shunt, ledit élément résistif comprenant deux circuits de mesure de la différence de potentiel produite dans le shunt établi suivant le parcours optimisé pour la configuration de calibration, desdits circuits de mesure étant situés dans un plan de symétrie longitudinal du shunt ayant leurs bornes respectives de départ reliées à un point commun de départ branché à la borne d'entrée du courant fort appliqué au shunt et leurs bornes respectives d'arrivée reliées à un point commun d'arrivée branché à une fiche coaxiale de sortie concentrique à la borne de sortie du courant fort appliqué au shunt.

11. Un shunt de mesure rectangulaire tel que revendiqué à la revendication 9, dans lequel l'élément résistif est constitué de deux ou plusieurs barres rectangulaires juxtaposées.

FIG. 1

FIG. 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | DE-B-1 216 981 (LICENTIA)<br>* Colonne 4, revendication 1 *<br>--- | 1-4 | G 01 R   1/20 |
| A | RGE REVUE GENERALE DE L'ELECTRICITE, no. 5, mai 1981, pages 332-343, Paris, FR; G. HORTOPAN et al.: "Etude, réalisation et performances de shunts coaxiaux pour la mesure précise de courants de courts-circuits élevés"<br>* En entier *<br>--- | 6 | |
| A | IEEE TRANS. ON POWER APPARATUS AND SYSTEMS, vol. PAS-96, no. 2, mars/avril 1977, pages 579-585, New York, US; R. MALEWSKI: "Micro-ohm shunts for precise recording of short-circuit currents"<br>* Page 585, figure 2 *<br>--- | 6 | |
| A | GB-A-2 056 182 (FERRANTI)<br>----- | | |

**DOMAINES TECHNIQUES RECHERCHES (Int. Cl.4)**

G 01 R

Le présent rapport a été établi pour toutes les revendications

| Lieu de la recherche | Date d'achèvement de la recherche | Examinateur |
|---|---|---|
| LA HAYE | 04-02-1988 | HOORNAERT W. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
.......................................................................
& : membre de la même famille, document correspondant

EPO FORM 1503 03.82 (P0402)